# EUROPÄISCHE PATENTSCHRIFT

(11) **EP 1 217 630 B1**
(45) Veröffentlichungstag und Bekanntmachung des Hinweises auf die Patenterteilung: **10.03.2010**
(21) Anmeldenummer: 01128794.3
(22) Anmeldetag: 04.12.2001
(51) Int. Cl.: G11C 29/00

(54) **Verfahren zur Prüfung von einer integrierten Schaltung**
Test method for integrated circuit
Procédé de test d'un circuit integré

(30) Priorität: 22.12.2000 DE 10064478
(43) Veröffentlichungstag der Anmeldung: 26.06.2002
(73) Patentinhaber: Atmel Automotive GmbH, 74072 Heilbronn (DE); Vishay Semiconductor GmbH, 74072 Heilbronn (DE)
(72) Erfinder: Eichin, Matthias, 74080 Heilbronn (DE); Kurz, Alexander, 74523 Schwäbisch Hall (DE)
(74) Vertreter: Koch, Bertram

(56) Entgegenhaltungen:
- EP-A- 0 535 776
- DE-A- 4 027 510
- DE-A1- 3 639 169
- DE-A1- 4 223 127
- DE-A1- 19 735 406
- US-A- 5 212 442
- US-A- 5 363 383

## Beschreibung

Die vorliegende Erfindung betrifft ein Verfahren zur Prüfung von einer integrierten Schaltung, gemäß dem Oberbegriff des Patentanspruchs 1, sowie eine Schaltungsanordnung zur Durchführung dieses Verfahrens.

Bei integrierten Schaltungen (ICs) werden nach dem Herstellungsprozeß elektrische Messungen zum Prüfen der Schaltkreise durchgeführt. Durch die hohe Komplexität ist es dabei notwendig neben den Ausgangssignalen der gesamten Schaltung, auch die Signale einzelner interner Funktionsgruppen einer Schaltung zu messen. In der Entwicklungsphase werden hierzu zusätzliche interne Kontaktflächen sogenannte Meßpads integriert, die einzelnen Schaltungsblöcken zugeordnet sind. Sofern die integrierten Schaltungen noch nicht in einem Gehäuse verschlossen sind, können an'diesen Meßpads Funktionskontrollen durchgeführt werden. Bei den fertigen integrierten Schaltungen werden für eine Überprüfung der korrekten Funktion einige der Meßpads mit externen Bondpads verbunden, um auch im assemblierten Zustand an zusätzlichen Ausgangspins die zu prüfenden Signale zu messen. Sowohl die zusätzlichen Meßpads innerhalb der integrierten Schaltungen, als auch die zusätzlichen Pins am fertigen IC benötigen eine additive Fläche, deren Anteil sich bei einer Miniaturisierung prozentual erhöht.

Beispiele für das bisherige Verfahren sind durch bekannte integrierte Schaltkreise (IC) wie beispielsweise der U2548 und der U2521 der Firma ATMEL Germany GmbH gegeben. Hierbei wurden ein Teil der innerhalb der integrierten Schaltung vorhandenen Meßpads zum Prüfen von Signalen einzelner Schaltungsfunktionen mit zusätzlichen Meßpads verbunden.

Ein weiteres nach dem bisherigen Stand der Technik arbeitendes Verfahren ist aus der Druckschrift EP 0535776 B1 bekannt. An einem zusätzlichen Eingangspin wird anhand eines anliegenden Signals und mittels einer internen Logik ein Testmodus aktiviert um damit an den weiteren Eingangspins der integrierten Schaltung ausgewählte zu prüfende Signale einzelner Schaltungseinheiten der integrierten Schaltung anzulegen.

Nachteilig bei den nach dem Stand der Technik bekannten Verfahren ist, daß für die Funktionskontrollen notwendigen, Flächen gerade bei kleinen, jedoch hochintegrierten Schaltkreisen einen erheblichen Anteil an der Gesamtfläche des Schaltkreises einnehmen, wobei sich die Fläche auf die Meßpads innerhalb der Schaltung und die zusätzlichen Pins, die zum externen Messen der Signale benötigt werden, aufteilt. Aufgrund des großen Anteils an der gesamten Chipfläche ist der dadurch verursachte Anteil an den Gesamtkosten einer Schaltung erheblich. Gerade bei kleinen Schaltungen, die in hohen Stückzahlen gefertigt werden, wirkt sich dies negativ auf deren Wirtschaftlichkeit aus.

Aus der DE 42 23 127 A1 ist weiterhin ein Schaltkreis zum Einschalten eines Prüfbetriebszustands bekannt, bei dem auch bei eingestelltem Prüfbetriebszustand normale Betriebseingaben an einem Eingangsanschluss angelegt werden können. Dazu weist die angegebene Schaltung eine Pegeldetektoreinheit zum Ermitteln eines Eingangssignalpögels, eine Triggereinheit zum Stabilisieren dieses Signalspegels sowie eine Kipp- und Verriegelungseinheit auf, die nach Maßgabe der Triggereinheit ein Testfreigabesional ausgibt. Somit kann eine Freigabe bzw. Sperrung des Prüfbetriebszustands durch negative Änderung eines augenblicklichen Eingangssignals realisiert werden.

Die US 5,363,383 offenbart einen Schaltkreis zum Erzeugen eines Modussteuersignals. Bei diesem wird über eine Steuerspannung, die an einem Ausgangsanschluss angelegt wird, in Abhängigkeit von einem Eingangssignal der Schaltung ein ungültiger Zustand ("illegal state") erzeugt, aufgrund dessen sich ein Modussteuersignal ergibt, das zum Steuern weiterer Schaltungsteile verwendbar ist. Dies setzt eine Abhängigkeit der Signale am Signaleingang und am Signalausgang voraus, um den genannten ungültigen Zustand zu erzeugen.

Die DE 40 27 510 A1 offenbart einen integrierten Schaltkreis (IC) mit Testfunktion, bei dem eine Test-Schaltlogik vorhanden ist, die ein Register zum Speichern von Daten zum Einstellen von Testbetriebsarten des IC aufweist. Gemäß einem Ausführungsbeispiel wird ein Eingangssignal, das bei einer Schreibperiode während einer Rücksetzzyklusperiode über ein Ausgangsanschluss des IC eingegeben wird, als Datenwert zum Einstellen von Testbetriebsarten in dem Register gespeichert.

Die US 5,212,442 beschreibt einen integrierten Schaltkreis, bei dem ein Eingangspin in Verbindung mit einem Testmodus-Detektor zum Erzeugen eines Testmodussignals für den integrierten Schaltkreis genutzt wird.

Aufgabe der vorliegenden Erfindung ist es, ein Verfahren anzugeben mit dem interne Signale einer integrierten Schaltung, unter Verwendung von bereits vorhandenen Pins für externe Funktionskontrollen, zur Verfügung gestellt werden. Eine weitere Aufgabe der Erfindung besteht darin, eine Schaltungsanordnung zur Durchführung des Verfahrens anzugeben, die sich einfach und kostengünstig herstellen läßt.

Die erstgenannte Aufgabe wird durch die Merkmale des Patentanspruches 1 gelöst. Die Schaltungsanordnung wird durch die Merkmale der Patentansprüche 9 und 10 beschrieben. Günstige Ausgestaltungsformen sind Gegenstand von Unteransprüchen.

Hiernach besteht das Wesen der Erfindung darin, daß die innerhalb einer integrierten Schaltung von einer Schaltungseinheit erzeugten Signale, die im normalen Betriebsmodus nicht an den Ausgängen messbar sind, für Funktionskontrollen als Prüfsignale auf die vorhandenen Signalausgänge zu schalten. Hierzu wird bei anliegender Versorgungsspannung an wenigstens einem Signalausgang der integrierten Schaltung ein bestimmter Potentialwert angelegt und damit die integrierte Schaltung in einen Testmodus umgeschaltet. Dadurch wird ein von einer Schaltungseinheit der integrierten Schaltung erzeugtes Prüfsignal an denselben Signalausgang gelegt. Um die Umschaltung in den Testmodus zuverlässig erreichen zu können, ist es erforderlich, daß der an dem Signalausgang angelegte Potentialwert einen Unterschied zu dem im normalen Betrieb der integrierten Schaltung an diesem Signalausgang anliegenden Wert der Ausgangsspannung aufweist. Dabei ist vorgesehen, dass der Potentialwert an dem Signalausgang mittels eines passiven Bauelementes, beispielsweise durch einen Widerstand, angelegt bzw. eingestellt wird.

Vorteilhaft gegenüber dem bisherigen Stand der Technik ist es, daß keine interne Meßpads bei den einzelnen Schaltungsteilen der Schaltungseinheit während des Schaltungsdesigns vorgesehen werden müssen und damit Chipfläche eingespart wird. Ferner werden keine zusätzlichen Pins und damit Bondpads zur Umschaltung der integrierten Schaltung in einen Testmodus oder zur Messung der Prüfsignale benötigt. Insbesondere bei integrierten Schaltungen deren Signalausgänge als "Open Collektor" mit "Pull Up" - Widerständen ausgeführt sind, läßt sich auf sehr kostengünstige Weise mittels eines Widerstandes ein Potentialwert einstellen, mit dem sich die integrierte Schaltung in einen Testmodus umschalten läßt. Ferner ist das neue Verfahren unabhängig davon, ob an einem Signaleingang der integrierten Schaltung ein Eingangssignal anliegt. Insbesondere lassen sich die Ausgangssignale von Schaltungsteilen der zu prüfenden integrierten Schaltung, die beispielsweise eine Oszillatorstufe aufweisen, als Prüfsignale an den Signalausgang legen. Des weiteren-ist auch möglich das Prüfsignal, bei einem an dem Signaleingang der integrierten Schaltung anliegenden Eingangssignal, zu messen, um damit insbesondere die signalverarbeitenden Schaltungsteile der Schaltungseinheit zu überprüfen.

In einer Weiterbildung des Verfahrens können an dem Signalausgang auch mehrere Potentialwerte angelegt werden. Durch eine Zuordnung der jeweiligen Potentialwerte zu unterschiedlichen Prüfsignalen können an einem einzigen Signalausgang nacheinander verschiedene Prüfsignale gemessen werden. Damit lassen sich bei integrierten Schaltungen, die nur einen einzigen Signalausgang aufweisen mit geringem Schaltungsaufwand nacheinander verschiedene Prüfsignale an einem einzigen Signalausgang analysieren.

In einer Weiterbildung des Verfahrens ist es vorteilhaft vor der Umschaltung der integrierten Schaltung in den Testmodus mittels einer Steuereinheit den Wert der am Signalausgang angelegten Potentialwert während eines vorgegebenen Zeitfensters auf Übereinstimmung mit einem Referenzwert zu prüfen und in einen zweiten Zeitfenster die integrierte Schaltung in den Testmodus zu schalten, sofern der am Signalausgang anliegende Potentialwert dem vorgegebenen Referenzwert entspricht. Es ist dabei vorteilhaft, wenn der am Signalausgang eingestellte Potentialwert zeitlich konstant ist und das Prüfsignal eine Wechselspannung darstellt. Damit können mit einem externen Meßaufbau die Gleichspannungskomponenten leicht abgetrennt werden. Gegenüber dem bisherigen Stand der Technik kann nach dem erfindungsgemäßen Verfahren eine Umschaltung einer integrierten Schaltung in einen Testmodus mittels eines einzigen Widerstandes auf besonders einfache und kostengünstige Weise durchgeführt werden.

Bei mehreren Signalausgängen ist es in einer Weiterbildung des Verfahrens möglich, daß die Steuereinheit den an dem Signalausgang eingestellten Potentialwert prüft und an einem weiteren Signalausgang das Prüfsignal anlegt. Vorteilhaft dabei ist, daß keine Überlagerung mit dem eingestellten Gleichspannungswert stattfindet und bei dem Prüfsignal ein Gleichspannungsanteil (offset) gemessen werden kann.

In einer anderen Weiterbildung des Verfahrens wird von der Steuereinheit der am Signalausgang eingestellte Potentialwert mit einem Signal eines Schaltungsteils der Schaltungseinheit eine Boole'sche Verknüpfung durchgeführt. Durch eine UND-Verknüpfung mit dem disjunkten Signalwert läßt sich beispielsweise verhindern, daß sich die integrierte Schaltung durch ein am Signalausgang anliegendes Potential in einen Testmodus umschalten läßt. Hierfür ist es vorteilhaft, wenn die Verknüpfung mit einer Ansteuerspannung von einer Ausgangsstufe der integrierten Schaltung durchgeführt wird. Durch diese Ausführungsform des erfindungsgemäßen Verfahrens läßt sich am Signalausgang besonders zuverlässig eine unerwünschte Überlagerung von dem Prüfsignal im Testmodus mit den im normalen Betrieb, d.h. beispielsweise bei anliegenden Eingangsignalen, anliegenden Ausgangsignalen verhindern.

Untersuchungen der Anmelderin haben gezeigt, daß es vorteilhaft ist, wenn in Abhängigkeit der am Signalausgang eingestellten Spannungswerte unterschiedliche Prüfsignale selektiert werden, indem beispielsweise von der Steuereinheit bei bestimmten Potentialwerten innerhalb der Schaltungseinheit gezielt Teile der Schaltung aktiviert oder deaktiviert werden. Damit lassen sich bei den Prüfsignalen sowohl mit, als auch ohne anliegendes Eingangssignal, bestimmte Signalformen bei den Prüfsignalen erzeugen.

In einer anderen Weiterbildung des erfindungsgemäßen Verfahrens wird die integrierte Schaltung in den Testmodus umgeschaltet, wenn der oder die am Signalausgang der integrierten Schaltung anliegende Potentialwert innerhalb eines Intervalls eines Fensterdiskriminators liegt. Dabei ist es vorteilhaft, wenn die Prüfsignale in ihren Signalhöhen, d.h. in ihren Amplituden und ihren Gleichspannungsoffsets mittels Signalverstärkern so eingestellt werden, daß der Gleichspannungsoffset des jeweiligen Prüfsignals dem am Signalausgang eingestellten Potentialwert entspricht und die maximale Amplitude des Prüfsignals innerhalb des durch den jeweiligen Fensterdiskriminator gegebenen Intervalls liegt. Sofern mit mehreren Fensterdiskriminatoren gearbeitet wird, lässt sich damit ein Übersprechen zwischen benachbarten Fenstern der Diskriminatoren verhindern. Zusätzlich wird der Gleichspannungswert am Signalausgang nur wenig verändert.

Zur Umsetzung des erfindungsgemäßen Verfahrens läßt sich die vorliegende neue Schaltungsanordnung in vorteilhafter Weise verwenden. Ein Vorteil der Integration einer Steuereinheit und wenigstens eines Schaltelementes gemäß der zweitgenannten Aufgabe der vorliegenden Erfindung ist, daß mit geringem zusätzlichem Schaltungsaufwand alle internen Meßpads vermeiden lassen. Ein weiterer Vorteil besteht darin, daß ein einziger Widerstand, der extern an den Signalausgang angeschlossen wird, genügt, um die integrierte Schaltung bei anliegender Versorgungsspannung in einen Testmodus zu schalten.

Das erfindungsgemäße Verfahren soll nachfolgend anhand eines Ausführungsbeispiel im Zusammenhang mit den Zeichnungen erläutert werden. Es zeigen, die
- Fig. 1: Eine erste Schaltungsanordnung zur Umsetzung des erfindungsgemäßen Verfahrens, und die
- Fig. 2: Eine zweite Schaltungsanordnung zur Umsetzung des erfindungsgemäßen Verfahrens.

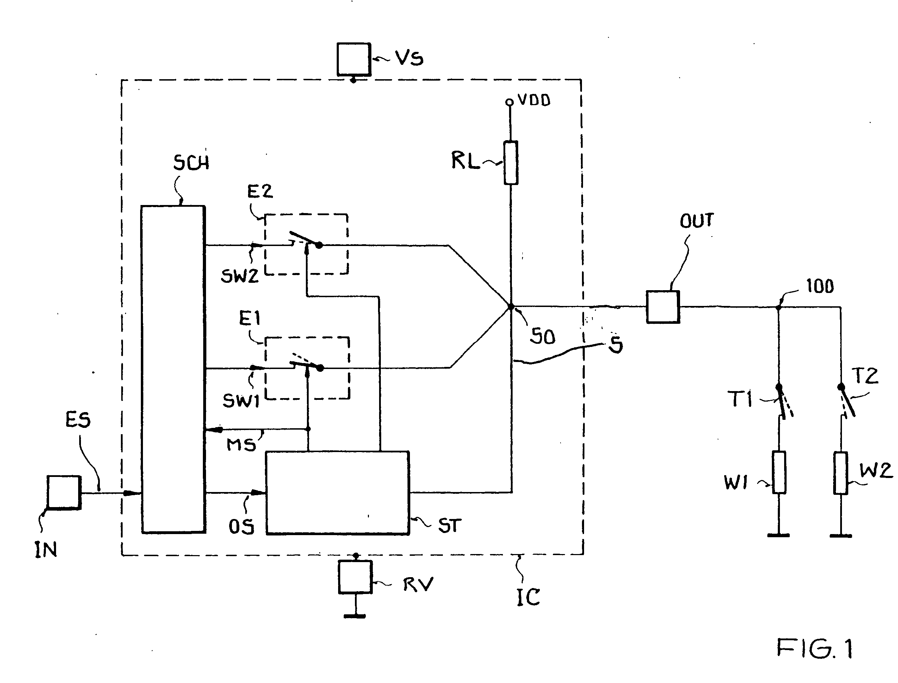

Die Aufgabe der in Figur 1 abgebildeten integrierten Schaltung IC ist es, die Ausgangsignale von einer Schaltungseinheit als Prüfsignale an einen Signalausgang der integrierten Schaltung zu legen, sofern an dem Signalausgang ein von außen angelegter Potentialwert, der beispielweise mittels eines externen Widerstands eingestellt werden kann, einem vorgegebenen Referenzwert entspricht. Hierzu weist die integrierte Schaltung IC einen Eingangspin IN und einen Ausgangspin OUT auf. Der Ausgangspin OUT ist extern über einen Knoten 100, an dem mittels eines Schalters T1 ein Widerstand W1 oder mittels eines Schalters T2 ein Widerstand W2 mit einem Referenzpotential RV verschaltet. Ferner weist die integrierte Schaltung noch einen Pin, an dem eine Versorgungsspannung VS liegt und einen Pin, der mit dem Referenzpotential RV verschaltet ist, auf.

Innerhalb der integrierten Schaltung IC sind zwei Funktionseinheiten enthalten. Die erste Funktionseinheit enthält die für den Normalbetrieb der integrierten Schaltung notwendigen Schaltungsfunktionen, die mit Ausnahme eines zwischen der Spannung VDD und einem Knoten 50 als "Pull Up" geschaltetes Lastelements RL durch eine Schaltungseinheit SCH dargestellt wird, die zweite Funktionseinheit umfaßt die Testmoduserkennung, die aus einer Steuereinheit ST und einem ersten und einem zweiten gesteuerten Schaltelement E1 und E2 besteht. Die Schaltungseinheit SCH weist einen ersten Eingang auf der mit dem Signaleingang IN der integrierten Schaltung IC verschaltet ist, und einen zweiten Eingang auf, an dem ein Signal MS anliegt, und eine erste Ausgangsleitung die mit der Steuereinheit ST verbunden ist, eine zweite Ausgangsleitung, die mit dem Schaltelement E1 verbunden ist, an der ein zu prüfendes Signal SW1 anliegt, und eine dritte Ausgangsleitung, die mit dem Schaltelement E2 verbunden ist, an der ein zu prüfendes Signal SW2 anliegt. Die Ausgänge der beiden Schaltelemente E1 und E2 sind mit dem Knoten 50 verbunden. Ferner ist der Knoten 50 mit dem Signalausgang OUT der integrierten Schaltung IC und mit einer Leitung 5 mit der Steuereinheit ST verbunden. Die Steuereinheit ST weist einen ersten Ausgang auf, an dem das Signal MS anliegt, der mit einem Steuereingang des Schaltelementes E1 und mit dem zweiten Eingang der Schaltungseinheit SCH verbunden ist und einen zweiten Ausgang der mit einem Steuereingang des Schaltelement E2 verschaltet ist.

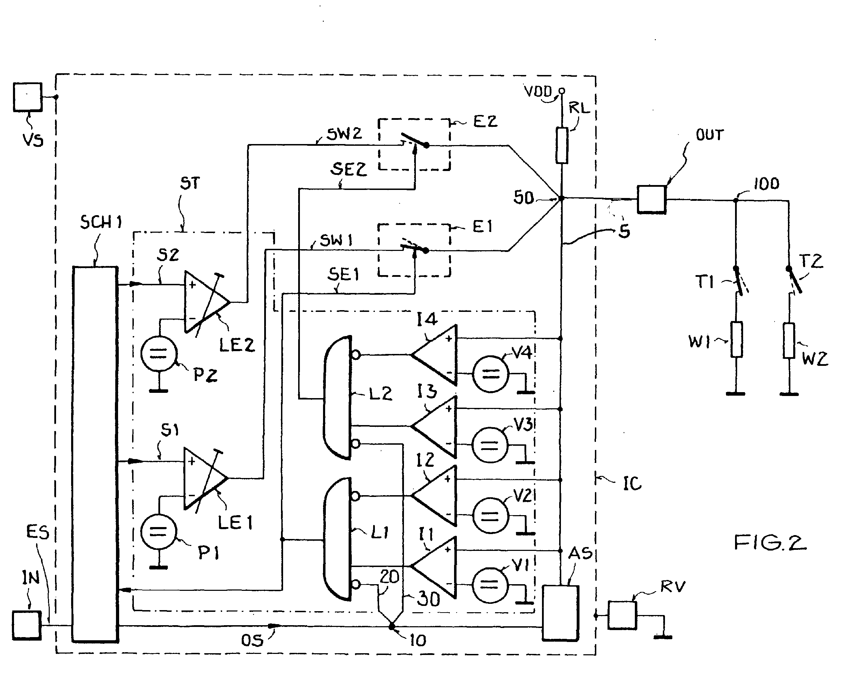

Im Folgenden wird die Funktionsweise der Schaltung erläutert. Hierbei lassen sich zwei Betriebsarten der integrierten Schaltung unterscheiden:
In der ersten Betriebsart ist der Widerstand W1 mittels des Schalters T1 von dem Signalausgang OUT getrennt. Da am Signalausgang OUT der integrierten Schaltung IC damit kein Potential anliegt, das einem durch die Steuereinheit ST vorbestimmten Wert entspricht, wird die integrierte Schaltung nicht in den Testmodus umgeschaltet. Sofern an dem Eingangspin IN ein Eingangssignal ES anliegt, wird an dem ersten Ausgang von der Schaltungseinheit SCH ein abgeleitetes Signal OS an die Steuereinheit ST angelegt. Die Steuereinheit ST gibt das Signal auf der Leitung 5 unverändert an den Knoten 50 weiter und legt damit das Signal OS als Ausgangssignal an dem Ausgang OUT der integrierten Schaltung IC an.
In der zweiten Betriebart, wird mittels des Schalters T1 durch den Widerstand W1 in Verbindung mit dem Lastelement RL am Ausgang OUT ein bestimmtes Potential eingestellt, wodurch die integrierte Schaltung IC in einen Testmodus umgeschaltet wird. Eine Schaltungsanordnung zur Potentialerkennung wird in Figur 2 erläutert. Durch die Umschaltung in den Testmodus wird von der Steuereinheit ST mittels des Signals MS innerhalb der Schaltungseinheit SCH ein vorbestimmter Schaltungsblock selektiert, der das Signal SW1 an das Schaltelement E1 ausgibt. Ferner wird von dem Signal MS das Schaltelement E1 geschloßen und das Signal SW1 als ein Prüfsignal an den Signalausgang OUT angelegt. Um das Gleichspannungspotential an dem Knoten 50 nur wenig zu beeinflussen, handelt es sich bei dem Prüfsignal SW1 um ein Wechselspannungssignal. Wird mittels des Schalters T1 der Widerstand W1 von dem Signalausgang OUT abgetrennt, steigt das Potential am Knoten 50 bis zur Spannung VDD an und die Steuereinheit ST schaltet die integrierte Schaltung IC in den normalen Betriebszustand zurück, d.h. mittels des Schaltelementes E1 wird das Signal SW1 von dem Knoten 50 abgetrennt und die Selektion des vorbestimmten Schaltungsblocks durch das Signal MS aufgehoben.

Die Aufgabe der in Figur 2 dargestellten integrierten Schaltung IC ist es, im Normalbetrieb ein Wechselspannungssignal zu liefern. Während die Außenbeschaltung der integrierten Schaltung IC mit der in Figur 1 beschriebenen Ausführungsform identisch ist, wird in einer Erweiterung der Ausführungsform von Figur 1 eine vorteilhafte Realisierung einer Steuereinheit ST dargestellt. In der dargestellten Ausführungsform ist die Umschaltung der integrierten Schaltung in den Testmodus von dem Ergebnis einer logischen Verknüpfung von dem eingestelltem Potentialwert und dem Ansteuersignal einer Ausgangstufe der integrierten Schaltung IC abhängig. Innerhalb der integrierten Schaltung IC ist der Eingang IN mit einem ersten Eingang eines Schaltungselement SCH1 verbunden. Ferner weist das Schaltelement SCH1 einen zweiten Eingang auf, an dem ein Signal MS anliegt, und einen ersten Ausgang, an dem ein Signal OS anliegt, der mit einem Knoten 10 verschaltet, und einen zweiten Ausgang, an dem ein erstes zu prüfendes Signal S1 anliegt, der mit einem nichtinvertierenden Eingang eines ersten Verstärkers LE1 verschaltet ist, und einen dritten Ausgang, an dem ein zweites zu prüfendes Signal S2 anliegt, der mit einem nichtinvertierenden Eingang eines zweiten Verstärkers LE2 verschaltet ist. Des weiteren ist mit dem Knoten 10 noch der Eingang einer Signalausgangstufe AS, beispielsweise ein Impedanzverstärker, verbunden und jeweils ein erster disjunkter Eingang 20 und 30 eines UND-Gatters L1 und L2 verschaltet. Der Ausgang der Signalausgangstufe AS ist mit dem Knoten 50 verschaltet, an dem außer dem Signalausgang OUT ein nach der Spannung VDD geschalteter Lastwiderstand RL und jeweils der Ausgang eines gesteuerten Schaltelements E1 und eines gesteuerten Schaltelementes E2 verbunden ist. Ferner ist mit dem Knoten 50 ein erster nichtinventierender Eingang eines Komparators I1 und eine erster nichtinventierender Eingang eines Komparators I2 verschaltet. An dem invertierenden Eingang des Komparators I1 liegt eine untere Schwellspannung V1 an die zusammen mit der am invertierenden Eingang des Komparators I2 anliegenden zweiten oberen Schwellspannung V2 einen Fensterdiskriminator bildet. Der Ausgang des Komparators I1 ist mit einem konjunkten Eingang eines UND-Gatters L1 verbunden, der Ausgang des zweiten Komparators I2 mit einem zweiten disjunkten Eingang eines UND-Gatters L1. Der Ausgang des Gatters L1, an dem ein Signal SE1 anliegt, ist sowohl mit dem Steuereingang eines Schaltelementes E1 als auch mit dem zweiten Eingang der Schaltungseinheit SCH1 verbunden. Außerdem ist der Knoten 50 mit einem ersten nichtinventierenden Eingang eines Komparators I3 und mit einem ersten nichtinventierenden Eingang eines Komparators I4 verschaltet. An dem invertierenden Eingang des Komparators L3 liegt eine untere Schwellspannung V3 an, die zusammen mit der an dem invertierenden Eingang des Komparators I4 anliegenden oberen Schwellspannung V4 einen zweiten Fensterdiskrimminator bildet. Der Ausgang des Komparators I3 ist mit einem konjunkten Eingang eines UND-Gatters L2 verbunden, der Ausgang des Komparators I4 ist mit dem zweiten disjunkten Eingang eines UND-Gatters L2 verschaltet. Der Ausgang des Gatters L2, an dem ein Signal SE2 anliegt, ist mit dem Steuereingang eines Lastelementes E2 verbunden. Ferner liegt an dem invertierenden Eingang des Verstärkers LE1 eine Referenzspannung P1 an. Der Ausgang des Verstärkers LE1, an dem das Signal SW1 anliegt, ist mittels des gesteuerten Schaltelementes E1 mit dem Knoten 50 verschaltet. Ferner liegt an der invertierenden Eingang des regelbaren Verstärkers LE2 eine Referenzspannung P2 an. Der Ausgang des Verstärkers LE2, an dem das Signal SW2 anliegt, ist mittels des gesteuerten Schaltelementes E2 mit dem Knoten 50 verschaltet.

Im Folgenden wird die Funktionsweise der integrierten Schaltung IC in Abhängigkeit der äußeren Beschaltung beschrieben. Es lassen sich zwei Betriebsarten unterscheiden:

In der ersten Betriebsart, die die normale Betriebsart darstellt, liegt am Signaleingang IN ein Eingangssignal ES an, aus dem von der Schaltungseinheit SCH1 das Eingangssignal OS für den Ausgangsverstärker AS abgeleitet wird. Da an dem Knoten 10 und damit an den beiden ersten Eingängen der Logikgatter L1 und L2 ein Signal anliegt, ist das Ergebnis beider UND-Verknüpfungen "nicht wahr". Damit bleibt das Potential des Knotens 50 unberücksichtigt, d.h. auch ein durch den Widerstand W1 eingestellter Potentialwert würde die integrierte Schaltung nicht in den Testmodus umschalten. In Folge bleiben die beiden gesteuerten Schaltelemente E1 und E2 geöffnet. An dem Signalausgang OUT liegt das verstärkte Signal OS an, wobei dies das Ausgangssignal im Normalbetrieb der integrierten Schaltung IC darstellt.

In der zweiten Betriebsart liegt an dem Knoten 10 kein Signal OS an. Damit wird die integrierte Schaltung IC durch eine äußere Beschaltung in einen Testmodus umgeschaltet werden, sofern der am Knoten 50 eingestellte Potentialwert innerhalb des Intervalls eines der beiden Fensterdiskriminatoren liegt. In der dargestellten Ausführungsform wird mittels des Schalters T1 durch den Widerstand W1 in Verbindung mit dem Lastwiderstand RL am Knoten 50 ein Potential eingestellt, welches innerhalb des durch den ersten Fensterdiskriminator gegebenen Spannungsintervalls liegt. Da nur an den drei Eingängen des Logikgatters L1 die Signale die richtige Polarität aufweisen, ist nur das Ergebnis der UND-Verknüpfung des Gatters L1 "wahr" und das Ausgangsignal SE1 wird auf "high" geschaltet. Gleichzeitig mit dem Schließen des Schaltelementes E1 wird von dem Signal SE1 in der Schaltungseinheit SCH1 ein vorbestimmter Schaltungsteil selektiert und eine Signalform erzeugt, die in Form des Signals S1 von dem Verstärker LE1 als Signal SW1 an den Knoten 50 angelegt wird. Damit liegt am Signalausgang OUT das zu prüfende Signal SW1 an. Wird der Schalter T1 geöffnet, steigt das Potential an dem Knoten 50 über den oberen Grenzwert des ersten Fensterdiskriminators an und das Ausgangsignal SE1 des Logikgatters L1 wird auf "low" geschaltet, da nun das Ergebnis seiner Verknüpfung "nicht wahr" ist. Die Selektion des vorbestimmten Schaltungsteils wird beendet und das Schaltelement E1 trennt das Signal SW1 von dem Knoten 50 ab. Durch das Lastelement RL wird der Knoten 50 auf den Wert der Spännung VDD angehoben (Pull up), solange keine weiteren Signale an den Knoten 50 zugeführt werden.

Wird mittels des Schalters T2 der Widerstand W2 mit dem Signalausgang OUT verbunden, stellt sich am Knoten 50 ein Potential ein das innerhalb des Intervalls des zweiten Fensterdiskriminator liegt. Damit ist nur das Ergebnis des Gatters L2 "wahr" und das Prüfsignal SW2 wird mittels des Schaltelementes E2 an den Signalausgang OUT gelegt. Wird der Widerstand W2 abgetrennt trennt das Gatter L2 mittels des Schaltelementes E2 das Prüfsignal SW2 von dem Signalausgang OUT ab und das Potential des Knotens 50 wird auf den Wert der Spannung VDD angehoben.

Damit die beiden Prüfsignale SW1 und SW2 den jeweiligen Gleichspannungswert am Knoten 50 nur wenig beeinflußen, oder es durch eine zu große Wechselspannungsamplitude der Signale SW1 und SW2 zu einer Verkopplung mit dem jeweiligen anderen Fensterdiskriminator kommt, werden die Signale S1 und S2 von den Verstärkern LE1 und LE2 in ihrer maximalen Amplitude als auch in dem Gleichspannungsoffset vorgegeben. Um einen möglichst großen Amplitudenhub zu erreichen, ist es vorteilhaft, den Gleichspannungsoffset der Signale SW1 und SW2 so zu wählen, daß dieser in der Mitte des durch den jeweiligen Fensterdiskriminator gegebenen Intervalls liegt. Sind die jeweiligen Schaltelemente E1 und E2 geöffnet liegen die Prüfsignale nur an den jeweiligen Eingängen der Schaltelemente E1 und E2 an.

Im Unterschied zu dem Logikgatter L1 ist der Ausgang des Logikgatters L2 ausschließlich mit dem Steuereingang des Schaltelementes E2 verbunden. Daher kann mit dem Signal SE2 keine Selektion d.h. eine Aktivierung oder Deaktivierung von Schaltungsfunktionen innerhalb des Schaltungseinheit SCH1 durchgeführt werden.

Abschließend sei angemerkt, daß die Anzahl der Prüfsignale mit dem neuen Verfahren nur durch die Amplitudengröße der Prüfsignale und den notwendigen Abständen der an dem Signalausgang anliegenden einzelnen Spannungswerten beschränkt wird.

## Patentansprüche

1. Verfahren zur Prüfung von einer integrierten Schaltung (IC), die eine Anzahl von Signalausgängen (OUT) aufweist und sich in einen Testbetrieb umschalten lässt und wenigstens eine Schaltungseinheit (SCH) aufweist, wobei
• zur Umschaltung in den Testmodus unabhängig von einem Signal an einem Eingang (IN) der integrierten Schaltung an einem der Signalausgänge (OUT) der zu prüfenden Schaltung ein Potentialwert angelegt wird, der einen Unterschied zu einem im normalen Betrieb der zu prüfenden integrierten Schaltung an diesem Signalausgang anliegenden Wert einer Ausgangsspannung aufweist,
• mittels einer Steuereinheit (ST) der Potentialwert geprüft und die integrierte Schaltung in Abhängigkeit von der Prüfung in einen Testmodus geschaltet wird, und
**dadurch gekennzeichnet, daß**
• im Testmodus wenigstens ein von der Schaltungseinheit (SCH) erzeugtes Prüfsignal (SW1, SW2) an wenigstens einen der Signalausgänge (OUT) der zu prüfenden Schaltung gelegt wird und
• der Potentialwert und das wenigstens eine Prüfsignal (SW1,SW2) an denselben Signalausgang (OUT) gelegt werden.

2. Verfahren nach Anspruch 1, **dadurch gekennzeichnet, daß** der Potentialwert an dem Signalausgang (OUT) mittels eines passiven Bauelements, beispielsweise eines Widerstands (W1, W2), erzeugt wird.

3. Verfahren nach Anspruch 1 oder 2, **dadurch gekennzeichnet, daß** im Testmodus die Schaltungseinheit mehrere Prüfsignale (SW1, SW2) erzeugt, die jeweils durch Anlegen bestimmter Potentialwerte an den Signalausgang (OUT) gelegt werden.

4. Verfahren nach einem der vorangegangenen Ansprüche, **dadurch gekennzeichnet, daß** innerhalb eines ersten vorgegebenen Zeitfensters das Potential an dem Signalausgang (OUT) mit einem vorgegeben Referenzwert (P1, P2, P3, P4) verglichen wird und in einem zweiten Zeitfenster die integrierte Schaltung (IC) in den Testmodus umgeschaltet wird.

5. Verfahren nach einem der vorangegangenen Ansprüche, **dadurch gekennzeichnet, daß** die Umschaltung in den Testmodus von dem Ergebnis einer Verknüpfung abhängt und die Verknüpfung zwischen dem am Signalausgang (OUT) angelegten Potentialwert und einem von dem Schaltungsteils (SCH) erzeugten Signal (OS) durchgeführt wird.

6. Verfahren nach einem der vorangegangenen Ansprüche, **dadurch gekennzeichnet, daß** mit dem Umschalten in den Testmodus innerhalb der Schaltungseinheit (SCH) Schaltungsblöcke aktiviert oder deaktiviert werden.

7. Verfahren nach einem der vorangegangenen Ansprüche, **dadurch gekennzeichnet, daß** der am Signalausgang (OUT) angelegte Potentialwert innerhalb eines Intervalls eines Fensterdiskrimminators liegt.

8. Verfahren nach einem der vorangegangenen Ansprüche, **dadurch gekennzeichnet, daß** die Signalhöhe des Prüfsignals (SW1, SW2) innerhalb des durch den Fensterdiskriminator vorgegebenen Spannungsintervalls liegt.

9. Schaltungsanordnung zur Umsetzung des erfindungsgemäßen Verfahrens nach einen der Ansprüche 1 bis 8, mit einer integrierten Schaltung (IC), die eine Anzahl von Signalausgängen (OUT), wenigstens ein Schaltelement (E1, E2) und wenigstens eine Schaltungseinheit (SCH) aufweist,
**dadurch gekennzeichnet, daß**
• die integrierte Schaltung (IC) zur Prüfung des Potentials an einem der Signalausgänge (OUT) eine Steuereinheit (ST) aufweist, die mit diesem Signalausgang (OUT) verbunden ist, und
• die Steuereinheit (ST) mit wenigstens einem Schaltelement (E1, E2) verbunden ist, und
• der Eingang des Schaltelementes (E1, E2) mit einem Ausgang der Schaltungseinheit (SCH) verbunden ist,
• der Ausgang des Schaltelements (E1, E2) mit einem der Signalausgänge (OUT) verbunden ist, und
• die Steuereinheit (ST) und der Ausgang des Schaltelementes (E1, E2) mit demselben Signalausgang (OUT) verbunden sind.

10. Schaltungsanordnung nach Anspruch 9,
**dadurch gekennzeichnet, daß**
• die Steuereinheit (ST) zur Anpassung der zu prüfenden Signale an das Potential des Signalausgangs (OUT) einen Verstärker (LE1, LE2) enthält, und
• der Eingang des Verstärkers (LE1, LE2) mit dem Ausgang einer Schaltungseinheit (SCH1) verbunden ist,
• der Ausgang des Verstärkers (LE1, LE2) mit dem Eingang des Schaltelements (E1, E2) verbunden ist,
• die Steuereinheit (ST) wenigstens zwei Komparatoren (I1, I2 und 13, I4), die einen Fensterdiskriminator bilden, enthält,
• und zur Verknüpfung der Prüfsignale (SW1, SW2) mit wenigstens einem weiteren Signal (OS) der Schaltungseinheit (SCH) ein Logikgatter (L1, L2) aufweist,
• der Eingang des Fensterdiskriminator mit dem Signalausgang (OUT) verbunden ist, und
• der Ausgang des Fensterdiskriminator mit dem Eingang eines Logikgatters (L1, L2) verbunden ist,
• der Ausgang des Logikgatters (L1, L2) mit dem Steuereingang des Schaltelements (E1, E2) verbunden ist, und
• zur Selektion vorgegebener Schaltungsteile innerhalb der Schaltungseinheit (SCH1) der Ausgang wenigstens eines Logikgatters (L1, L2) auch mit der Schaltungseinheit (SCH1) verbunden ist.

## Claims

1. Method of checking an integrated circuit (IC) which comprises a number of signal outputs (OUT) and can be switched over in a test operation and which has at least one circuit unit (SCH), wherein
- for switching over in the test mode independently of a signal at an input (IN) of the integrated circuit there is applied to one of the signal outputs (OUT) of the circuit to be checked a potential value having a difference from a value, which is applied to this signal output in normal operation of the integrated circuit to be checked, of an output voltage, and
- the potential value is checked by means of a control unit (ST) and the integrated circuit is switched to a test mode in dependence on the check,
**characterised in that**
- in the test mode at least one test signal (SW1, SW2) generated by the circuit unit (SCH) is applied to at least one of the signal outputs (OUT) of the circuit to be checked and
- the potential value and the at least one test signal (SW1, SW2) are applied to the same signal output (OUT).

2. Method according to claim 1, **characterised in that** the potential value is generated at the signal output (OUT) by means of a passive component, for example a resistance (W1, W2).

3. Method according to claim 1 or 2, **characterised in that** in the test mode the circuit unit generates several test signals (SW1, SW2) which are applied to the signal output (OUT) by respective application of specific potential values.

4. Method according to any one of the preceding claims, **characterised in that** within a first predetermined time window the potential at the signal output (OUT) is compared with a predetermined reference value (P1, P2, P3, P4) and in a second time window the integrated circuit (IC) is switched over to the test mode.

5. Method according any one of the preceding claims, **characterised in that** the switching over to the test mode depends on the result of a logical linking and the logical linking is performed between the potential value applied to the signal output (OUT) and a signal (OS) generated by the circuit part (SCH).

6. Method according to any one of the preceding claims, **characterised in that** circuit blocks are activated or deactivated within the circuit unit (SCH) by the switching over to the test mode.

7. Method according to any one of the preceding claims, **characterised in that** the potential value applied to the signal output (OUT) lies within an interval of a window discriminator.

8. Method according to any one of the preceding claims, **characterised in that** the signal level of the test signal (SW1, SW2) lies within the voltage interval predetermined by the window discriminator.

9. Circuit arrangement for realisation of the method according to the invention according to any one of claims 1 to 8, comprising an integrated circuit (IC) which comprises a plurality of signal outputs (OUT), at least one switch element (E1, E2) and at least one circuit unit (SCH), **characterised in that**
- the integrated circuit (IC) comprises, for checking the potential at one of the signal outputs (OUT), a control unit (ST) connected with this signal output (OUT), and
- the control unit (ST) is connected with at least one switch element (E1, E2), and
- the input of the switch element (E1, E2) is connected with an output of the circuit unit (SCH),
- the output of the switch element (E1, E2) is connected with one of the signal outputs (OUT) and
- the control unit (ST) and the output of the switch element (E1, E2) are connected with the same signal output (OUT).

10. Circuit arrangement according to claim 9, **characterised in that**
- the control unit (ST) includes an amplifier (LE1, LE2) for matching the signals to be checked to the potential of the signal output (OUT), and
- the input of the amplifier (LE1, LE2) is connected with the output of a circuit unit (SCH1),
- the output of the amplifier (LE1, LE2) is connected with the input of the switch element (E1, E2),
- the control unit (ST) includes at least two comparators (I1, 12 and I3, 14), which form a window discriminator,
- and the circuit unit (SCH) comprises a logic gate (L1, L2) for logical interlinking of the test signals (SW1, SW2) with at least one further signal (OS),
- the input of the window discriminator is connected with the signal output (OUT), and
- the output of the window discriminator is connected with the input of a logic gate (L1, L2),
- the output of the logic gate (L1, L2) is connected with the control input of the switch element (E1, E2), and
- for selection of predetermined circuit parts within the circuit unit (SCH1) the output of at least one logic gate (L1, L2) is also connected with the circuit unit (SCH1).

## Revendications

1. Procédé pour la vérification d'un circuit intégré (IC) qui présente un nombre de sorties de signal (OUT) et que l'on peut commuter en un fonctionnement en mode test et qui présente au moins une unité de circuit (SCH) selon lequel :
• pour commuter dans le mode test indépendamment d'un signal sur une entrée (IN) du circuit intégré, on applique une valeur de potentiel sur une des sorties de signal (OUT) du circuit à vérifier, valeur qui présente une différence en tension de sortie par rapport à une valeur de fonctionnement normal de ce circuit intégré à vérifier se trouvant à cette sortie de signal,
• on vérifie la valeur de potentiel au moyen d'une unité de commande (ST) et on commute le circuit intégré dans un mode test en fonction de la vérification
**caractérisé en ce que** :
• en mode test au moins un signal de test (W1, W2) généré par l'unité de circuit (SCH) est appliqué à au moins une des sorties de signal (OUT) du circuit à vérifier et,
• la valeur de potentiel et l'au moins un signal de test (SW1,SW2) sont appliqués à la même sortie de signal (OUT).

2. Procédé selon la revendication 1 **caractérisé en ce que** la valeur de potentiel à la sortie de signal (OUT) est générée au moyen d'un composant passif, par exemple une résistance (W1, W2).

3. Procédé selon la revendication 1 ou 2 **caractérisé en ce que** dans le mode test l'unité de circuit génère plusieurs signaux de test (SW1, SW2) qui à chaque fois sont obtenus en appliquant une valeur de potentiel correspondante à la sortie de signal (OUT).

4. Procédé selon l'une des revendications précédentes **caractérisé en ce qu'**à l'intérieur d'une première fenêtre de temps prédéterminée, le potentiel à la sortie de signal (OUT) est comparé à une valeur de référence prédéterminée (P1, P2, P3, P4) et dans une deuxième fenêtre de temps, le circuit intégré est commuté dans le mode test.

5. Procédé selon l'une des revendications précédentes **caractérisé en ce que** la commutation en mode test dépend du résultat d'une concaténation et **en ce que** la concaténation est effectuée entre la valeur de potentiel appliquée à la sortie de signal (OUT) et un signal (OS) généré par une partie du circuit (SCH).

6. Procédé selon l'une des revendications précédentes **caractérisé en ce que** par la commutation dans le mode test on active ou on désactive dans l'unité de circuit (SCH) des blocs de circuit.

7. Procédé selon l'une des revendications précédentes **caractérisé en ce que** la valeur du potentiel à la sortie de signal (OUT) se trouve à l'intérieur d'un intervalle d'une fenêtre de discriminateur.

8. Procédé selon l'une des revendications précédentes **caractérisé en ce que** l'amplitude du signal de test (SW1, SW2) se trouve à l'intérieur d'un intervalle de tension prédéterminé de la fenêtre de discriminateur.

9. Circuit pour la mise en oeuvre du procédé selon l'invention selon l'une des revendications 1 à 8 avec un circuit intégré (IC) qui présente un nombre de sorties de signal (OUT), au moins un élément de coupure (E1, E2) et au moins une unité de circuit (SCH)
**caractérisé en ce que** :
• le circuit intégré (IC) pour la vérification du potentiel sur une des sorties de signal (OUT) présente une unité de commandes (ST) qui est reliée à cette sortie de signal (OUT) et
• l'unité de commande (ST) est reliée à au moins un élément de coupure (E1, E2) et,
• l'entrée de l'élément de coupure (E1, E2) est reliée à une sortie de l'unité de circuit (SCH),
• la sortie de l'élément de coupure (E1, E2) est reliée à l'une des sorties de signal (OUT) et
• l'unité de commande (ST) et la sortie de l'élément de coupure sont reliées à la même sortie de signal (OUT).

10. Circuit selon la revendication 9
**caractérisé en ce que**
• l'unité de commande (ST) comporte un amplificateur (LE1, LE2) pour adapter les signaux à vérifier au potentiel de la sortie de signal (OUT),
• l'entrée de l'amplificateur (LE1, LE2) est reliée à la sortie d'une unité de circuit (SCH1),
• la sortie de l'amplificateur (LE1, LE2) est reliée à l'entrée de l'élément de coupure (E1, E2),
• l'unité de commande (ST) comprend au moins deux comparateurs (I1, I2, I3, I4) qui définissent une fenêtre de discriminateur,
• et pour la concaténation des signaux de vérification (SW1, SW2) avec au moins un signal supplémentaire (OS), l'unité de circuit (SCH) présente une porte logique (L1, L2),
• l'entrée de la fenêtre de discriminateur est reliée à la sortie de signal (OUT) et,
• la sortie de la fenêtre de discriminateur est reliée à l'entrée d'une porte logique (L1, L2),
• la sortie de la porte logique (L1, L2) est reliée à l'entrée de commande de l'élément de coupure (E1, E2) et
• afin de sélectionner la partie de circuit prédéterminée à l'intérieur de l'unité de circuit (SCH1), la sortie d'au moins une porte logique (L1, L2) est également reliée à l'unité de circuit (SCH1).
